Europäisches Patentamt

(19) European Patent Office

Office européen des brevets

(11) Publication number : **0 633 658 A2**

(12) **EUROPEAN PATENT APPLICATION**

(21) Application number : **94304941.1**

(22) Date of filing : **05.07.94**

(51) Int. Cl.⁶ : **H03G 3/32**

(30) Priority : **06.07.93 US 88065**

(43) Date of publication of application : **11.01.95 Bulletin 95/02**

(84) Designated Contracting States : **DE FR**

(71) Applicant : **Hughes Aircraft Company**
**7200 Hughes Terrace,**
**P.O. Box 80028**
**Los Angeles, California 90080-0028 (US)**

(72) Inventor : **Lathrop, James I.**
**3336-3A Punta Alta**
**Laguna Hills, California 92653 (US)**

(74) Representative : **Colgan, Stephen James**
**CARPMAELS & RANSFORD**
**43 Bloomsbury Square**
**London WC1A 2RA (GB)**

(54) **Voice activated transmission coupled AGC circuit.**

(57)    A voice processing technique, that may be implemented as an algorithm or logic or a method, that electronically determines if a digitized sound source contains a voice signal component at periodic instances in time. The present invention uses spectral estimation techniques combined with statistical analysis and discrete decision logic to determine a voice or no-voice decision. The present invention uses a measurement of standard deviation of each energy band combined with a neural network to determine which bands may be used to detect voice modulation. Second-order statistics are used to determine which energy bands are most reliable for detection of a voice signal. The neural network is used to make the decision based on past values of these statistics. In addition, the voice decision logic controls the gain of its microphone input to provide a superior automatic gain control microphone. The present invention updates the AGC gain only during voice modulation. The present invention operates in noisy environments while maintaining high accuracy, resulting in very few false activations. The present invention adapts to the ambient noise level automatically, eliminating the need for a manual level control. The present invention makes decisions quickly, reducing problems associated with chopping off the beginning of words. The present invention controls the AGC function, and this control eliminates the effects of runaway gain when no voice signal is present, saturation when the circuit is reactivated, and also ensures consistent gain with speech containing long pauses between phrases.

FIG. 1.

## BACKGROUND

The present invention relates generally to automatic gain control (AGC) circuits and processing methods, and more particularly, to a voice activated transmission coupled automatic gain control circuit and processing method.

A number of voice activated transmission (VOX) algorithms and circuits have been proposed over the past few years. It is believed that none of them has used a measurement of standard deviation of each energy band combined with a neural network to determine which bands may be used to detect voice modulation. Updating the AGC gain only during voice modulation is also not found in prior VOX systems.

Conventional voice activated transmission (VOX) algorithms and circuits are described in "The ARRL Handbook for the Radio Amateur", published by the American Radio Relay League, Sixty-sixth Edition, 1989. Conventional VOX circuitry and VOX bias control is generally described in Chapter 12 at page 12-24 and 12-25. The voice operate switch (VOX) and its future trends are generally discussed in Chapter 13 at pages 13-11 and 13-12, while a drawing illustrating a basic VOX system is shown on page 13-9.

Therefore, it is an objective of the present invention to provide a voice activated transmission (VOX) circuit and processing method that uses a measurement of standard deviation of each energy band combined with a neural network to determine which bands may be used to detect voice modulation. It is a further objective of the present invention to provide a voice activated transmission (VOX) circuit and processing method that updates AGC gain during voice modulation.

## SUMMARY OF THE INVENTION

The present invention is a voice processing technique, that may be implemented as an algorithm or logic or a process, that electronically determines if a digitized sound source contains a voice signal component at periodic instances in time. The present invention uses spectral estimation techniques combined with statistical analysis and discrete decision logic to determine a voice or no-voice decision. The present invention uses a measurement of standard deviation of each energy band combined with a neural network to determine which bands may be used to detect voice modulation. While there have been algorithms designed to perform this task using averaging, the present invention uses second-order statistics to determine which energy bands are most reliable for detection of a voice signal. The neural network is used to make the decision based on past values of these statistics. In addition, the voice decision logic controls the gain of its microphone input to provide a superior automatic gain control microphone. The present invention updates the AGC gain only during voice modulation.

The present invention performs voice activated transmission (VOX) of voice signals that is reliable in either quiet or noisy environments. It also performs automatic gain control on the microphone input. The present invention is superior to prior VOX systems for a number of reasons. The present invention operates in noisy environments while maintaining high accuracy, resulting in very few false activations. The present invention adapts to the ambient noise level automatically, eliminating the need for a manual VOX level control. The present invention makes decisions quickly, reducing problems associated with chopping off the beginning of words. The VOX logic of the present invention controls the calculation of AGC gain factors, and this control eliminates the effects of runaway gain when no voice signal is present, saturation when the circuit is reactivated, and also ensures consistent gain with speech containing long pauses between phrases.

The present invention may be used whenever hands-free operation of a microphone is desirable. It is particularly useful in high noise or changing environments. Such applications include, but are not limited to, communications in automobiles, airplanes, trains, tanks, airports, factories, and construction sites.

## BRIEF DESCRIPTION OF THE DRAWINGS

The various features and advantages of the present invention may be more readily understood with reference to the following detailed description taken in conjunction with the accompanying drawings, wherein like reference numerals designate like structural elements, and in which:

Fig. 1 illustrates a voice activated transmit system employing a VOX-coupled automatic gain control in accordance with the principles of the present invention;

Fig. 2 shows a graph that is a pictorial representation of an energy band comparison for eight bands;

Fig. 4 shows one embodiment of a neural network voice decision logic employed in the present invention;

Fig. 5 shows a graph representing threshold versus sample rate frequency;

Fig. 3 shows a flow diagram illustrative of one method in accordance with the principles of the present invention; and

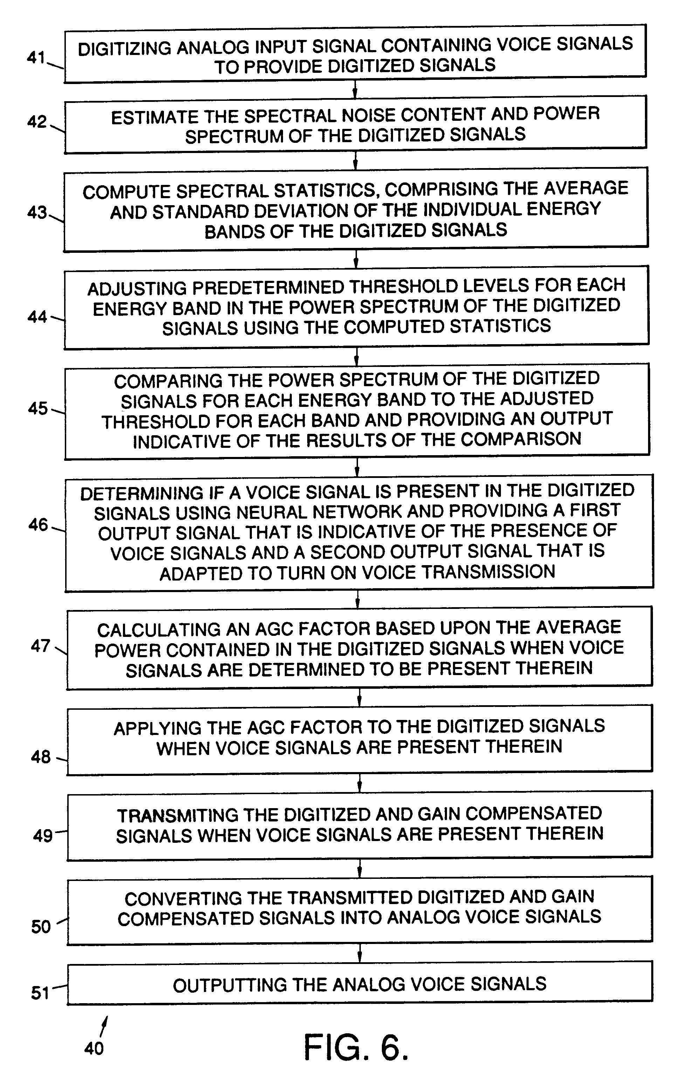

Fig. 6 shows a series of graphs illustrating operation of the VOX activated transmit system of the present invention.

**DETAILED DESCRIPTION**

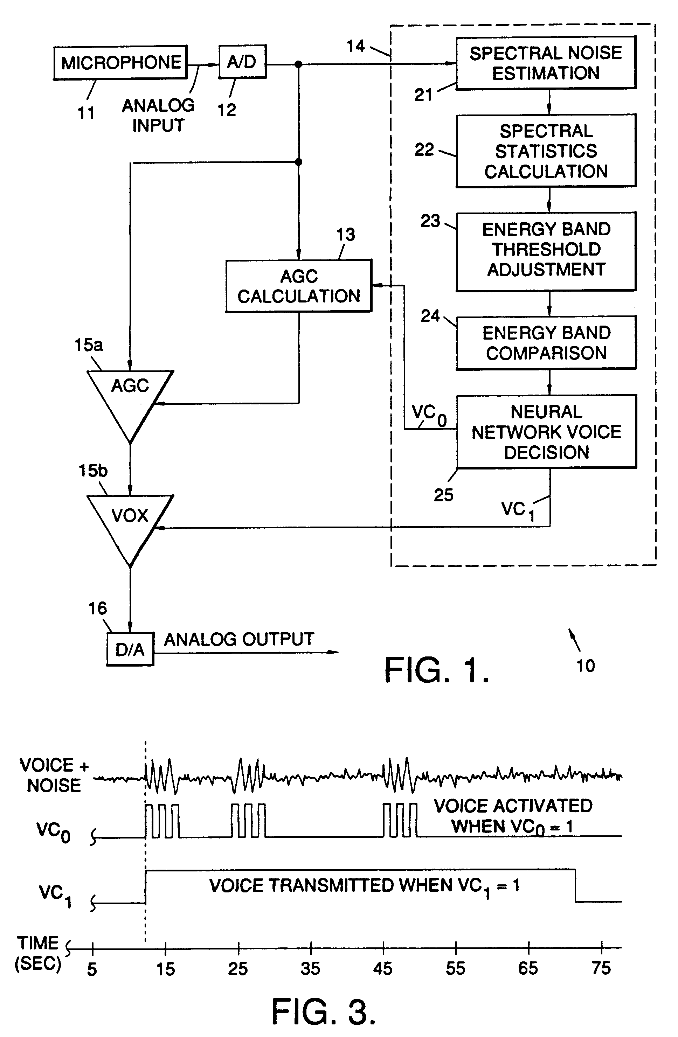

Referring to the drawing figures, Fig. 1 illustrates a voice activated transmit (VOX) system 10 employing VOX-coupled automatic gain control in accordance with the principles of the present invention. It is to be understood that while the voice activated transmit system 10 of the present invention is described herein in terms of an algorithm, logic, or a process, it may be implemented in software or hardware as is well-understood in the art.

A voice input signal (analog input signal) derived from a microphone 11, for example, is digitized in an analog to digital converter (A/D) 12 and then is coupled to three different logic functions, including AGC calculation logic 13, voice activated transmit (VOX) decision logic 14, and AGC and VOX data manipulation logic 15a, 15b. The VOX decision logic 14 is comprised of noise estimation logic 21, statistical calculation logic 22, threshold adjustment logic 23, band comparison logic 24, and neural network decision logic 25. Logical outputs ($VC_0$, $VC_1$) from the VOX decision logic 14 are coupled to the AGC calculation logic 13 and to the VOX data manipulation logic 15b. The output from the VOX data manipulation logic 15b is converted to an analog voice signal by a digital to analog converter (D/A) 16 that provides an analog output from the voice activated transmit system 10.

The analog-to-digital and digital-to-analog converters 12, 16 are conventional and are used to change the analog input stream from the microphone 11 into digital data that is processed and then convert the processed digital data back into an analog signal for output. There are no specific requirements for the precision or sampling speed of these converters 12, 16 except that speed and resolution affect both the performance of the voice activated transmit system 10 and the computation resources necessary to implement the algorithm in real time.

The VOX decision logic 14 will now be described in detail. The spectral noise estimation logic 21 may employ one of several well-known techniques for determining a power estimate for a number of frequency bands given a sequence of data. Such well-known processes include fast Fourier transform (FFT) with windowing and fast Fourier transform (FFT) using overlap, for example. The sequence of data may be any length; however, larger sequences provide for better results. The estimates are provided on a periodic basis, and the higher the sample period, the better the performance.

The spectral statistics computation logic 22 uses the power spectrum generated in the spectral noise estimation logic 21 to generate statistics about each band of the spectrum. The average and standard deviation of each energy band are computed over a time period, then used to update threshold levels in the subsequent processing logic.

The are many well-known techniques available for determining the average and standard deviation of each energy band over a period of time. One such technique for computing the statistics given an energy spectrum is described below that may be employed in the present invention.

Let

$$\left\{ \begin{array}{c} N_0(0) \cdots N_0(S\text{-}1) \\ N_1(0) \cdots N_1(S\text{-}1) \\ \vdots \\ N_M(0) \cdots N_M(S\text{-}1) \end{array} \right\}$$

be the spectral estimation of M.S digitized input samples, $N_i(k)$ is the $i^{th}$ spectral estimation at the $k^{th}$ energy band, M is the number of spectral samples, and S is the number of energy bands. The statistical calculation is performed as follows. The average of the $j^{th}$ band is given by:

$$AVE_j = \frac{1}{M} \sum_{i=0}^{M} N_i(j)$$

and the standard deviation of the jth band is given by:

$$SDEV_j = \sqrt{\frac{1}{M}\sum_{i=0}^{M} \frac{(N_i(j) - AVE_j)^2}{M - 1}}$$

This calculation is carried out every M spectra.

The energy band threshold adjustment computation logic 23 performs one of the key functions in the system 10. As averages and standard deviations are generated for each energy band by the spectral statistics computation logic 22, they are used to update a threshold level for each band in the energy band threshold adjustment computation logic 23. The threshold level for the energy band is based on the average ($AVE_j$) and standard deviation ($SDEV_j$) so that a high percentage of the sampled energy bands fall below this level, during a non-voice situation, and after adaption occurs. This has the effect of de-emphasizing bands in which the energy level of the band is erratic, or changes repeatedly, over time. These energy bands have a high standard deviation. The other important component of the calculation of threshold levels is the amount the threshold levels are changed when new values are computed. Several time constants are used depending on how long the last computed threshold values have been above or below the real threshold values; the longer the time period, the higher the time constants. By assigning a zero or very small time constant to short periods, threshold values are not changed during speech periods. However, by assigning large time constants to longer time periods, a very fast adaption time is achieved.

The threshold adjustment provided by the energy band threshold adjustment logic 23 is computed for each energy band. The adjustment is computed based on how long the $AVE_j + (SDEV_j \cdot X)$ has been higher or lower than the threshold, where X may range over positive numbers. Typical values for X range from 3 to 5. Thus the equations are dependent on previous computations as shown in the following sample table. In this table, $Y = AVE \cdot (SDEV \cdot X)$.

| The number of consecutive past | $T_O$ = old threshold value |
|---|---|
| Y values less than the threshold at that time | $T_N$ = new threshold value |
| 0 | $T_N = T_O$ |
| 1 | $T_N = T_O$ |
| 2-3 | $T_N = T_O + 0.0001(T_O - T_N)$ |
| 4-5 | $T_N = T_O + 0.001(T_O - T_N)$ |
| 6-10 | $T_N = T_O + 0.01(T_O - T_N)$ |
| 11-20 | $T_N = T_O + 0.05(T_O - T_N)$ |
| 21-100 | $T_N = T_O + 0.075(T_O - T_N)$ |
| > 100 | $T_N = T_O + 0.1(T_O - T_N)$ |

A similar table is used for past values that are greater than their respective thresholds. Note that the values and conputations in the tables are not critical, and change with respect to sample rate and the number of spectra processed for statistics. In general the tables control how fast the system 10 adapts to noise in the environment.

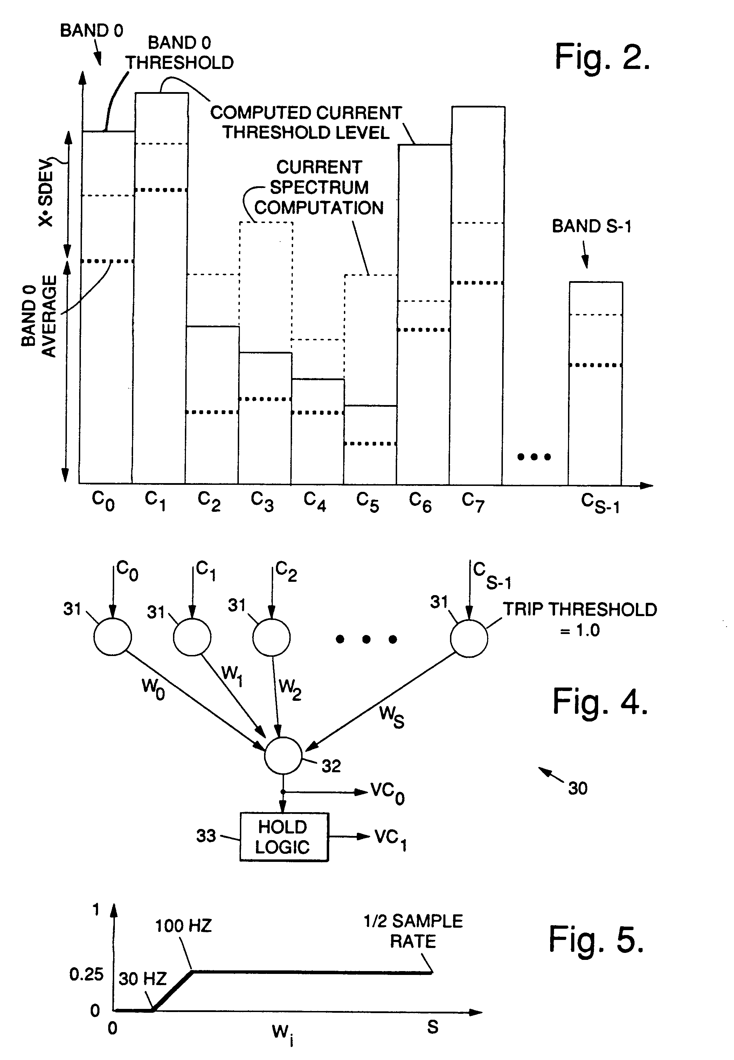

The energy band comparison logic 24 compares the original power spectrum estimation to the threshold levels. If the original power spectrum is greater than the threshold for an energy band, then a one is output, otherwise a zero is output. Together, all the energy bands from a string of zeros and ones that are used to stimulate the inputs of a neural network 30 (Fig. 4) in the subsequent logic.

Referring to Fig. 2 it shows a graph that is a pictorial representation of an energy band comparison for a predetermined number (S) of bands as is provided by the energy band comparison logic 24. The current spectrum computation is shown having a thin dashed line, the computed current threshold level is shown as a solid line, and the band average is shown as a thick dashed line. There are S values shown in Fig. 2 (0, 0, 1, 1, 1, 1, 0, ..., 0) that correspond to ($C_0$, $C_1$, $C_2$, $C_3$, $C_4$, $C_5$, $C_6$, ..., $C_{S-1}$), respectively. These values are applied as inputs to the neural network voice decision logic 25. The graph shown in Fig. 2 shows a typical computation of the comparison and the resulting binary digits that are produced. For example, band 0 has a computed threshold level that is greater than the current spectrum computation. Thus, during this spectrum computation, $C_0$ is given a value of 0. This value is subsequently fed to the neural network 30 (Fig. 4) in the neural network voice decision logic 25 described below. Similarly, bands 2, 3, 4, and 5 all have current threshold levels below the current spectrum computation, yielding binary values of 1 for $C_2$, $C_3$, $C_4$ and $C_5$.

The neural network voice decision logic 25 may employ a conventional neural network 30 (Fig. 4) such as a perceptron decision network, for example. The perceptron decision network is well-known in the art and will not be described in detail herein. However, it is to be understood that other neural network topologies may be employed such as a multiple layer neural network using back-propagation training procedures, for example. Whatever decision logic is used to implement the neural network voice decision logic 25, the neural network 30 outputs two signals, $VC_0$ and $VC_1$. The $VC_0$ signal is used to control the AGC calculation logic 15a and is active only when a voice signal is present. The $VC_1$ signal is derived from the $VC_0$ signal and operates the VOX data manipulation logic 15b and turns on voice transmission by way of the VOX data manipulation logic 15b. The $VC_1$ signal is derived from the $VC_0$ signal in the following manner. The $VC_1$ signal is on whenever the $VC_0$ signal is on, and the $VC_1$ signal is on two seconds after termination of $VC_0$ activation. The $VC_1$ signal operates a gate that controls the VOX data manipulation logic 15b if an audio signal at the microphone 11 is transmitted to the output D/A converter. Once a voice signal has been detected, the VOX data manipulation logic 15b remains on until no voice signals have been detected for a predetermined interval of time, such as two seconds, for example. Fig. 3 shows a series of graphs illustrating operation of the VOX activated transmit system 10 of the present invention.

The neural network 30 (perceptron decision network) employed in the neural network voice decision logic 25 is illustrated in Fig. 4. The neural network 30 is comprised of a plurality of neural network nodes 31 having inputs $C_0$, $C_1$, ... $C_S$ derived from the energy band comparison logic 24. Outputs of the respective neural network nodes 31 comprise weights $W_0$, $W_1$, ... $W_S$. The weights $W_0$, $W_1$, ... $W_S$ are applied to a single output neural network node 32 which corresponds to an ON decision by the neural network 30. The output of the output neural network node 32 corresponds to the $VC_0$ signal. Hold logic 33 is coupled to the output of the output neural network node 32 and the $VC_1$ signal is provided thereby. The hold logic 33 holds the $VC_1$ signal high for the predetermined period of time.

Fig. 5 shows a graph representing weights of the nodes in the neural network 30 versus frequency (energy bands). Based on the sample rate and the number of bands in the estimated spectrum, the weights in the neural network 30, weights $W_0$ through $W_{S-1}$ are assigned. It is well-known how to interpret an energy band as a frequency and determine the weight from the graph. It is to be understood that this is illustrative of one possible manner in which weights may be assigned. Other procedures well-known to those skilled in the art may also be employed. As indicated above, this procedure is not dependent on the particular set of weights.

The $VC_0$ signal is one if there is a strong probability a voice signal is present, and is zero otherwise. The $VC_0$ signal is computed by the output node 32 of the neural network 30 in the neural network voice decision logic 25. The $VC_1$ signal is derived from the $VC_0$ signal using hold logic 33 described below. The $VC_0$ signal is one (turned on) if $n_1$ consecutive outputs from the output node 32 are one. The value of $n_1$ may typically range from 1 to 100. Typical values are 2-7. The $VC_0$ signal remains on until $n_2$ consecutive output signals from the output node 32 are zero. Typical values are 1-10. The $VC_1$ signal is on if the $VC_0$ signal is turned on. The $VC_1$ signal is turned off if the $VC_0$ signal has been zero for at least $X_1$ seconds. Typical values of $X_1$ are between 0.5 and 2.0 seconds.

The $VC_0$ and $VC_1$ signals affect the AGC and VOX as follows. The $VC_0$ signal is used to calculate the AGC value by controlling when samples are used in the AGC calculation. When the $VC_0$ signal is active (1, indicating that voice is present), input samples are used to computing new AGC values. When $VC_0 = 0$, (no voice present) the AGC is not updated. As mentioned above, the $VC_1$ signal is derived from the $VC_0$ signal and is used to transmit the voice signal when voice is present. The VOX function is given by ($VC_1 \cdot$ input sample), where $VC_1$ is equal to 0 or 1.

The AGC factor is determined by averaging the power of the analog voice (input) signal only during times when the $VC_0$ signal is active (high or one).

$$X = \Sigma \, (INPUT)^2$$

where the last n values were $VC_0 < 1$.

If $AGC_n > AGC_0$,

then

$$AGC_n = AGC_0 + (AGC_N - AGC_0) \cdot F_1$$

else

$$AGC_n = AGC_0 + (AGC_N - AGC_0) \cdot F_2.$$

A typical value for $F_1$ is 0.001 and the typical value for $F_2$ is 0.01.

The AGC calculation logic 13 computes a gain value for full-scale digital values based on the average root-mean-squared (RMS) values for a period of time. A selectable time constant determines the slew rate of the AGC. However, the AGC calculation logic 13 only computes the average (RMS) and new AGC gain factors when samples contain voice data determined by the $VC_0$ signal.

Fig. 6 shows a flow diagram illustrative of one method 40 that provides for voice activated transmission and automatic gain control of analog signals containing voice signals in accordance with the principles of the present invention. The first step of the method 40 is digitizing analog input signal containing voice signals to provide digitized signals, as is indicated in step 41. The next step is to estimate the spectral noise content, as is indicated in step 42. The next step is to compute spectral statistics, comprising the average and standard deviation of the individual energy bands of the digitized signals over time, as is indicated in step 43. The next step is to adjust predetermined threshold levels for each energy band in the power spectrum of the digitized signals using the computed statistics, as is indicated in step 44. The next step is to compare the power spectrum of the digitized signals for each energy band to the adjusted threshold for each band and providing an output indicative of the results of the comparison, as is indicated in step 45.

The next step is to determine if a voice signal is present in the digitized signals using the neural network and providing a first output signal ($VC_0$) that is indicative of the presence of the voice signals and a second output signal ($VC_1$) that is adapted to turn on voice transmission, as is indicated in step 46. The next step is to calculate an AGC factor based upon the average power contained in the digitized signals when voice signals are determined to be present therein, as is indicated in step 47. The next step is to apply the AGC factor to the digitized signals when voice signals are present therein, as is indicated in step 48. The next step is to transmit the digitized and gain compensated signals when voice signals are present therein, as is indicated in step 49. The next step is to convert the transmitted digitized and gain compensated signals into analog voice signals, as is indicated in step 50. Finally, the analog voice signals are output, as is indicated in step 51.

The voice activated transmission system 10 of the present invention may be used whenever hands-free operation of the microphone 11 is desirable. The present sustem 10 is particularly useful in high noise or changing environments. Such applications include, but are not limited to, communications in automobiles, airplanes, trains, tanks, airports, factories, and construction sites.

Thus there has been described a new and improved voice activated transmission coupled automatic gain control circuit. It is to be understood that the above-described embodiment is merely illustrative of some of the many specific embodiments which represent applications of the principles of the present invention. Clearly, numerous and other arrangements can be readily devised by those skilled in the art without departing from the scope of the invention.

**Claims**

1. A voice activated transmit system comprising:

input means for receiving an analog voice input signal;

analog to digital converter means for digitizing the analog voice input signal to provide a digitized voice signal;

noise estimation means for determining estimates of power spectra for a predetermined number of frequency bands in the digitized voice signal on a periodic basis;

spectral statistical calculation means for processing the power spectra to generate statistics about each band of the spectrum that comprise average power and standard deviation during a predetermined time period;

threshold adjustment means for computing a threshold adjustment for each energy band based on how long the average power above or below predetermined threshold levels;

energy band comparison means for comparing the estimates of the power spectra to the threshold levels, and if a power spectrum is greater than the threshold level for an energy band, then a one is output, otherwise a zero is output; and

neural network voice decision means for generating a logical signal ($VC_1$) that is adapted to activate voice transmission by the system;

voice activated transmit data manipulation logic for receiving the digitized voice input signal and for receiving the logical signal ($VC_1$) therefrom that outputs voice signals when voice signals are present in the voice input signal; and

a digital to analog converter for converting digitized voice signals into analog voice output signals.

2. The voice activated transmit system of Claim 1 wherein the neural network voice decision means generates a second logical signal ($VC_0$) that is active when a voice signal is present, and wherein the system further comprises:

automatic gain compensation calculation means for receiving the digitized voice signals and for receiving the second logical signal ($VC_0$), for calculating and outputting gain factors for a predetermined period of time;

automatic gain compensation means for receiving the digitized voice signals and the computed gain factors for compensating the digitized voice signals in response thereto.

3. A voice activated transmit system comprising:

a microphone adapted to receive an analog voice input signal;

an analog to digital converter coupled to the microphone for digitizing the analog voice input signal to provide a digitized voice signal;

voice activated transmit decision logic coupled to the analog to digital converter and which comprises:

noise estimation logic for determining an estimate of the power spectra for a number of frequency bands in the digitized voice signal on a periodic basis;

spectral statistical calculation logic for processing the power spectrum generated by the spectral noise estimation logic to generate statistics about each band of the spectrum comprising an average power and standard deviation are computed over a predetermined time period;

threshold adjustment logic for computing a threshold adjustment for each energy band based on how long the average power above or below a predetermined threshold level for each band;

energy band comparison logic for comparing the estimates of the power spectra to the threshold levels, and if a power spectrum is greater than the threshold level for an energy band, then a one is output, otherwise a zero is output; and

neural network voice decision logic for generating first and second logical output signals ($VC_0$, $VC_1$) and wherein the first logical output signals ($VC_0$) is adapted to control the AGC calculation logic and is active when a voice signal is present, and wherein the $VC_1$ signal is adapted to activate voice transmission by way of the voice activated transmit data manipulation logic;

automatic gain compensation calculation logic coupled to the analog to digital converter for calculating gain values for full-scale digital values based on average root-mean-squared values for a period of time;

automatic gain compensation logic having a first input coupled to the analog to digital converter for receiving the digitized analog voice input signal and having a second input coupled to the neural network voice decision logic for receiving the $VC_0$ output signal therefrom, and having an output coupled to the automatic gain compensation logic for applying AGC gain factors thereto;

voice activated transmit data manipulation logic having a first input coupled to the automatic gain compensation logic for receiving the compensated digitized analog voice input signal therefrom, and having a second input coupled to the voice activated transmit decision logic for receiving the second logical output signal ($VC_1$) therefrom, for outputting voice signals in response thereto; and

a digital to analog converter coupled to the the voice activated transmit data manipulation logic for converting digitized voice signals into an analog voice output signals.

4. The voice activated transmit system of Claim 3 wherein the spectral statistical calculation logic computes the spectral estimates wherein the average of the $j^{th}$ band is given by:

$$AVE_j = \frac{1}{M} \sum_{i=0}^{M} N_i(j)$$

and the standard deviation of the jth band is given by:

$$SDEV = \frac{1}{M} \sum_{i=0}^{M} \frac{(N_i(j) - AVE_j)^2}{M - 1}$$

wherein

7

$$\left\{ \begin{array}{c} N_0(0)\cdots N_0(S\text{-}1) \\ N_1(0)\cdots N_1(S\text{-}1) \\ \vdots \\ N_M(0)\cdots N_M(S\text{-}1) \end{array} \right\}$$

is the spectral estimation of M·S digitized input samples, $N_i(k)$ is the $i^{th}$ spectral estimation at the $k^{th}$ energy band, M is the number of spectral samples, and S is the number of energy bands, and whereinand wherein this calculation is carried out every M spectra.

5. The voice activated transmit system of Claim 3 wherein the neural network is comprised of a plurality of neural network nodes having inputs $C_0$, $C_1$, ... $C_{S-1}$ derived from the energy band comparison logic, an output neural network node, and hold logic coupled to an output of the output neural network node, and wherein outputs of the respective neural network nodes comprise weights $W_0$, $W_1$, ... $W_{S-1}$ that are applied to the output neural network node whose output comprises the first logical output signal ($VC_0$), and wherein the hold logic is adapted to provide the second logical output signal ($VC_1$).

6. A method that provides for voice activated transmission and automatic gain control of analog signals containing voice signals, said method comprising the steps of:

digitizing analog input signal containing voice signals to provide digitized signals;

estimating the spectral noise content and power spectrum of the digitized signals;

computing spectral statistics, comprising the average and standard deviation of each energy band of the digitized signals;

adjusting predetermined threshold levels for each energy band in the power spectrum of the digitized signals using the computed statistics;

comparing the power spectrum of the digitized signals for each energy band to the adjusted threshold for each band and providing an output indicative of the results of the comparison;

determining if a voice signal is present in the digitized signals using neural network and providing a first output signal ($VC_0$) that is indicative of the presence of the voice signals and a second output signal ($VC_1$) that is adapted to turn on voice transmission;

calculating an AGC factor based upon the average power contained in the digitized signals when voice signals are determined to be present therein

applying the AGC factor to the digitized signals when voice signals are present therein;

transmitting the digitized and gain compensated signals when voice signals are present therein;

converting the transmitted digitized and gain compensated signals into analog voice signals; and

outputting the analog voice signals.

MICROPHONE → A/D → ANALOG INPUT

11 — MICROPHONE
12 — A/D

14 → SPECTRAL NOISE ESTIMATION — 21

SPECTRAL STATISTICS CALCULATION — 22

23 — ENERGY BAND THRESHOLD ADJUSTMENT

24 — ENERGY BAND COMPARISON

13 — AGC CALCULATION

$VC_0$ → NEURAL NETWORK VOICE DECISION

25 — $VC_1$

15a — AGC

15b — VOX

16 — D/A → ANALOG OUTPUT

**FIG. 1.**   10

VOICE + NOISE

$VC_0$   VOICE ACTIVATED WHEN $VC_0 = 1$

$VC_1$   VOICE TRANSMITTED WHEN $VC_1 = 1$

TIME (SEC)   5   15   25   35   45   55   65   75

**FIG. 3.**

9

Fig. 2.

BAND 0

BAND 0
THRESHOLD

COMPUTED CURRENT
THRESHOLD LEVEL

CURRENT
SPECTRUM
COMPUTATION

BAND S-1

X•SDEV

BAND 0
AVERAGE

$c_0$  $c_1$  $c_2$  $c_3$  $c_4$  $c_5$  $c_6$  $c_7$  • • •  $c_{S-1}$

$c_0$    $c_1$    $c_2$    $c_{S-1}$

31    31    31    • • • •    31    TRIP THRESHOLD
= 1.0

$W_0$    $W_1$    $W_2$    $W_S$

Fig. 4.

30

32

$VC_0$

33    HOLD
LOGIC    $VC_1$

1

100 HZ

1/2 SAMPLE
RATE

0.25

30 HZ

0

0    $W_i$    S

Fig. 5.

41 — DIGITIZING ANALOG INPUT SIGNAL CONTAINING VOICE SIGNALS TO PROVIDE DIGITIZED SIGNALS

42 — ESTIMATE THE SPECTRAL NOISE CONTENT AND POWER SPECTRUM OF THE DIGITIZED SIGNALS

43 — COMPUTE SPECTRAL STATISTICS, COMPRISING THE AVERAGE AND STANDARD DEVIATION OF THE INDIVIDUAL ENERGY BANDS OF THE DIGITIZED SIGNALS

44 — ADJUSTING PREDETERMINED THRESHOLD LEVELS FOR EACH ENERGY BAND IN THE POWER SPECTRUM OF THE DIGITIZED SIGNALS USING THE COMPUTED STATISTICS

45 — COMPARING THE POWER SPECTRUM OF THE DIGITIZED SIGNALS FOR EACH ENERGY BAND TO THE ADJUSTED THRESHOLD FOR EACH BAND AND PROVIDING AN OUTPUT INDICATIVE OF THE RESULTS OF THE COMPARISON

46 — DETERMINING IF A VOICE SIGNAL IS PRESENT IN THE DIGITIZED SIGNALS USING NEURAL NETWORK AND PROVIDING A FIRST OUTPUT SIGNAL THAT IS INDICATIVE OF THE PRESENCE OF VOICE SIGNALS AND A SECOND OUTPUT SIGNAL THAT IS ADAPTED TO TURN ON VOICE TRANSMISSION

47 — CALCULATING AN AGC FACTOR BASED UPON THE AVERAGE POWER CONTAINED IN THE DIGITIZED SIGNALS WHEN VOICE SIGNALS ARE DETERMINED TO BE PRESENT THEREIN

48 — APPLYING THE AGC FACTOR TO THE DIGITIZED SIGNALS WHEN VOICE SIGNALS ARE PRESENT THEREIN

49 — TRANSMITING THE DIGITIZED AND GAIN COMPENSATED SIGNALS WHEN VOICE SIGNALS ARE PRESENT THEREIN

50 — CONVERTING THE TRANSMITTED DIGITIZED AND GAIN COMPENSATED SIGNALS INTO ANALOG VOICE SIGNALS

51 — OUTPUTTING THE ANALOG VOICE SIGNALS

40

# FIG. 6.